# EUROPEAN PATENT APPLICATION

(11) **EP 2 479 800 A1**
(43) Date of publication of application: **25.07.2012**
(21) Application number: 10816993.9
(22) Date of filing: 05.08.2010
(51) Int. Cl.: H01L 31/042, C08G 18/48

(54) **SOLAR BATTERY MODULE AND PROCESS FOR PRODUCTION THEREOF**

(30) Priority: 18.09.2009 JP 2009216901
(71) Applicant: Sony Chemical & Information Device Corporation, Tokyo 141-0032 (JP)
(72) Inventor: UCHIMI Toshiharu, Kanuma-shi Tochigi 322-8502 (JP); NISHIMOTO Masahiro, Kanuma-shi Tochigi 322-8502 (JP)
(74) Representative: Müller-Boré & Partner Patentanwälte
(86) International application number: PCT/JP2010/063300
(87) International publication number: WO 2011/033880

(57) **Abstract**

A solar cell module comprises a glass substrate, a first sealing resin layer, a solar cell connected to a tab wire, a second sealing resin layer, and a protective sheet, which are laminated. The second sealing resin layer is formed from a blend polymer of a thermoplastic polyurethane resin having an ester-type polyol unit and a thermoplastic polyurethane resin having an ether-type polyol unit. The blend ratio of the thermoplastic polyurethane resin having the ester-type polyol unit to the thermoplastic polyurethane resin having the ether-type polyol unit in the blend polymer is 20:80 to 50:50 by mass.

## Description

### TECHNICAL FIELD

The present invention relates to a solar cell module and a production method thereof.

### BACKGROUND ART

There has been proposed a solar cell module in which a sealing resin sheet is disposed on both surfaces of a solar cell obtained by attaching lead wires on a surface electrode of a light receiving face thereof in advance, and the solar cell is interposed between a glass substrate and a protective sheet (i.e., back sheet) and then is subjected to vacuum lamination (Patent Document 1). As such a sealing resin sheet for use in such a solar cell module, a particular sheet has been widely used, with the sheet obtained by adding a cross-linking agent, a UV absorber, and the like to an ethylene-vinyl acetate resin (EVA resin) that is superior in transparency, flexibility, adhesion, tensile strength, and weather resistance, and forming it into a sheet.

### PRIOR ART DOCUMENTS

### PATENT DOCUMENT

Patent Document 1: JP2004-311571A

### SUMMARY OF THE INVENTION

### PROBLEMS TO BE SOLVED BY THE INVENTION

A solar cell module is used over a long period of time under severe environment such as exposure to sunlight and weathering outdoors. For this reason, the adhesion force of a sealing resin is decreased, and a slight amount of moisture may penetrate the inside of the module, particularly from a protective sheet side. In this case, an ethylene-vinyl acetate resin is partially hydrolyzed to produce acids, and the produced acids corrode electrodes of the solar cell module. As a result, there have been the problems in which performance of the solar cell module deteriorates. Further, since an EVA resin is a combustible resin, use of a resin showing favorable burning resistance as a sealing resin is required in the solar cell module.

The present invention is achieved to solve the conventional problems as described above. It is an object of the present invention to provide a solar cell module, in which a decrease in adhesion force of a used sealing resin is suppressed not to corrode electrodes even when the solar cell module is used over a long period of time under severe environment such as exposure to sunlight and weathering, and which shows favorable burning resistance.

### MEANS FOR SOLVING THE PROBLEM

The inventors have researched a resin showing favorable adhesion force, difficulty in hydrolysis, and burning resistance as a sealing resin on at least a protective sheet (back sheet) side of a solar cell module instead of an EVA resin conventionally used. The inventors have found that properties of a blend polymer of a thermoplastic polyurethane resin having an ester-type polyol unit which has comparatively strong adhesion force and comparatively high hydrolytic properties and a thermoplastic polyurethane resin having an ether-type polyol unit which has comparatively weak adhesion force and comparatively low hydrolytic properties are properties which reflect intensely preferable properties of the respective resins (i.e., favorable adhesion and difficultly in hydrolysis), but mitigate unpreferable properties, and show favorable burning resistance. Then the present invention has been completed.

The present invention provides a solar cell module comprising a module substrate, a first sealing resin layer, a solar cell connected to a tab wire, a second sealing resin layer, and a protective sheet, which are laminated, wherein
the second sealing resin layer is formed from a blend polymer including a thermoplastic polyurethane resin having an ester-type polyol unit and a thermoplastic polyurethane resin having an ether-type polyol unit, and a blend ratio of the thermoplastic polyurethane resin having the ester-type polyol unit to the thermoplastic polyurethane resin having the ether-type polyol unit in the blend polymer is 20:80 to 50:50 by mass.

Further, the present invention provides a method for producing the above-described solar cell module comprising: putting a laminated body obtained by laminating a module substrate, a first sealing resin sheet, a solar cell connected to or temporarily attached on a tab wire, a second sealing resin sheet, and a protective sheet, in a vacuum laminator; and performing vacuum lamination to simultaneously integrate the laminated body, wherein as the second sealing resin sheet, used is a sealing resin sheet which is formed from a blend polymer including a thermoplastic polyurethane resin having an ester-type polyol unit and a thermoplastic polyurethane resin having an ether-type polyol unit, and has a blend ratio of the thermoplastic polyurethane resin having the ester-type polyol unit to the thermoplastic polyurethane resin having the ether-type polyol unit in the blend polymer of 20:80 to 50:50 by mass.

Moreover, the present invention provides a sealing resin sheet for a solar cell module which is formed from a blend polymer including a thermoplastic polyurethane resin having an ester-type polyol unit and a thermoplastic polyurethane resin having an ether-type polyol unit, wherein a blend ratio of the thermoplastic polyurethane resin having the ester-type polyol unit to the thermoplastic polyurethane resin having the ether-type polyol unit in the blend polymer is 20:80 to 50:50 by mass.

In addition, the present invention provides a sealing resin sheet with a protective layer for a solar cell module, wherein the above-described sealing resin sheet for a solar cell module is laminated on a protective sheet.

### EFFECTS OF THE INVENTION

In the solar cell module of the present invention, the blend polymer of the thermoplastic polyurethane resin having the ester-type polyol unit and the thermoplastic polyurethane resin having the ether-type polyol unit in the predetermined blend ratio is formed into a sheet, and the sheet is used as the second sealing resin layer on a back sheet side. The blend polymer shows favorable adhesion force, difficulty in hydrolysis (i.e., properties for substantially suppressing corrosion of electrodes, and properties for suppressing deterioration in adhesion force), and favorable burning resistance. Therefore, the solar cell module of the present invention can maintain the initial performances over a long period of time, and shows favorable burning resistance. If the first sealing resin layer is composed of the same material as in the second sealing resin layer, the solar cell module of the present invention can maintain the initial performances over a longer period of time, and shows more favorable burning resistance.

Further, according to the production method of the present invention, the sealing resin sheet for a solar cell obtained by performing treatment in a vacuum laminator to form the blend polymer of the thermoplastic polyurethane resin having the ester-type polyol unit and the thermoplastic polyurethane resin having the ether-type polyol unit in a predetermined blend ratio into a sheet is used to form at least the second sealing resin layer. Accordingly, the solar cell module simultaneously integrated by the treatment in a vacuum laminator can be produced with high productivity.

### BRIEF DESCRIPTION OF THE DRAWINGS

Fig. 1 is a schematic cross-sectional view of a solar cell module of the present invention.
Fig. 2 is a schematic cross-sectional view when a flexible lid is taken off from a vacuum laminator main body for use in production of the solar cell module.
Fig. 3 is a diagram illustrating vacuum lamination performed in a vacuum laminator.

### MODE(S) FOR CARRYING OUT THE INVENTION

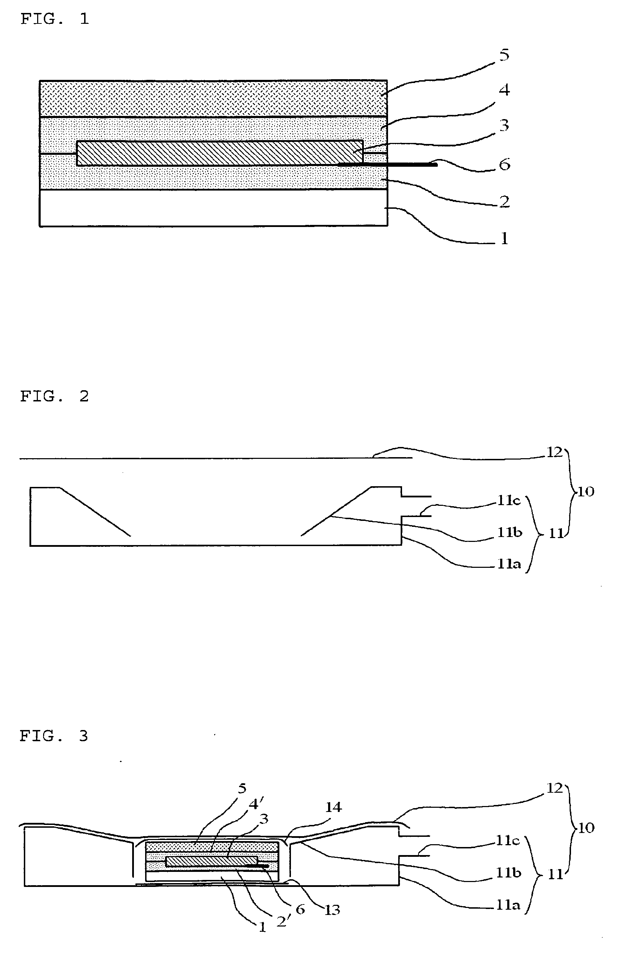

The solar cell module of the present invention will be descried with reference to Fig. 1.

As shown in the schematic cross-sectional view (Fig. 1) of the solar cell module of the present invention, the solar cell module has a structure in which a first sealing resin layer 2, a solar cell 3 connected to a tab wire 6 for continuity to outside of the solar cell module, a second sealing resin layer 4, and a protective sheet 5 are sequentially laminated on a module substrate 1. Further, the tab wire 6 is connected to a surface electrode on a module substrate 1 side (i.e., light receiving face) of the solar cell 3, preferably using a conductive adhesive (not shown). This is preferable because of an increase in productivity and stress relaxation. A configuration of such layers itself is basically the same as that of the conventional solar cell module.

The solar cell module of the present invention is characterized in that at least the second sealing resin layer 4 is formed from a blend polymer of a thermoplastic polyurethane resin having an ester-type polyol unit (hereinafter sometimes referred to as ester polyol polyurethane) and a thermoplastic polyurethane resin having an ether-type polyol unit (hereinafter sometimes referred to as ether polyol polyurethane). Use of such a blend polymer can impart favorable adhesion force and difficulty in hydrolysis to the second sealing resin layer 4. In addition, flame resistance in accordance with UL94 standard can be imparted to the solar cell module. At least the second sealing resin layer 4 should be composed of a particular blend polymer since a moisture penetrates the solar cell module mainly from a protective sheet side.

With regard to the blend ratio of ester polyol polyurethane to ether polyol polyurethane, if the proportion of the former is too small, the adhesion force is decreased, while if it is too large, hydrolysis is likely to occur, and thus corrosion of a surface electrode and deterioration in adhesion force are likely to occur. Therefore, the blend ratio is 20:80 to 50:50 by mass, and preferably 30:70 to 50:50 by mass.

The above-described blend polymer can include other thermoplastic resins, a silane-coupling agent, a cross-linking agent, an antioxidant, and the like, if needed.

The thickness of the second sealing resin layer depends on the size of the solar cell 3, and is usually 0.1 to 0.6 mm, and preferably 0.2 to 0.5 mm.

The first sealing resin layer in the present invention may be an EVA resin as being conventional, but is preferably formed from a particular blend polymer similar to the second sealing resin layer. By doing so, better adhesion force and difficulty in hydrolysis can be imparted to the first sealing resin layer 2. In addition, better flame resistance in accordance with UL94 standard can be imparted to the solar cell module.

As the solar cell 3, the protective sheet 5, the tab wire 6, and the conductive adhesive, the known solar cell, protective sheet, tab wire, and a conductive adhesive can be used, respectively.

For example, as the solar cell 3, a single-crystalline silicon solar cell, a polycrystalline silicon solar cell, a thin-film silicon solar cell, an HIT solar cell, a CIGS-type thin-film solar cell, and the like can be used. As the protective sheet 5, a resin sheet of polyester, polyimide, or polyamide, a glass plate, and the like can be used. Further, as the tab wire 6, a tab ribbon obtained by plating a 150-µm copper ribbon with a 40-µm solder, and the like can be used. As the conductive adhesive, a thermoplastic conductive adhesive obtained by dispersing conductive particles such as metal particles or resin particles coated with metal in a thermoplastic binder resin which has been conventionally used for connection with this kind of tab wire, and the like can be used.

A blend polymer for the formation of the second sealing resin layer 4 and the first sealing resin layer 2 (i.e., a polymer obtained by mixing ester polyol polyurethane and ether polyol polyurethane in a specific blend ratio) is usually molded into a sheet form, and the sheet is used. Such a sheet is a sealing resin sheet for a solar cell module as one aspect of the present invention. Such a sealing resin sheet for a solar cell module can be produced by an extrusion molding method, in which a molten blend polymer is extruded from a die into a sheet form, or by a casting method, in which a blend polymer coating liquid prepared by diluting the blend polymer with an organic solvent such as toluene is applied to a peeling sheet by a known coating method and dried. The thickness of the sealing resin sheet for a solar cell module can be appropriately selected depending on use purposes.

Further, the second sealing resin layer 4 and the protective sheet 5 are integrated in advance to increase the productivity of a solar cell module, and thus can be used as a sealing resin sheet with a protective layer. Such a sheet is also a sealing resin sheet with a protective layer for a solar cell module as one aspect of the present invention. Herein, integration can be performed using a known technique, for example, an extrusion molding method, a casting method, and the like.

The solar cell 3 of the present invention can be produced using a known vacuum laminator. That is, a laminated body obtained by laminating a module substrate, a first sealing resin sheet to become a first sealing resin layer, a solar cell connected to or temporarily attached on a tab wire, a second sealing resin sheet to become a second sealing resin layer, and a protective sheet is put in the vacuum laminator, and vacuum lamination is performed to simultaneously integrate the laminated body. In this manner, the solar cell module of the present invention as shown Fig. 1 can be produced. Here, the solar cell connected to the tab wire is, for example, in a state where the tab wire has been strongly connected to the solar cell with a solder or a conductive adhesive before the vacuum lamination. The solar cell temporarily attached on the tab wire means, for example, one in a state where the tab wire is attached enough to attach the tab again after peeling at normal temperature through the adhesion force of a conductive adhesive.

One example of vacuum laminators used in the present invention will be described below. As illustrated in Fig. 2, a vacuum laminator 10 includes a main body 11 made of metal such as stainless steel for the formation of a lamination space, and a flexible lid 12 made of a silicone rubber sheet which covers the main body 11 to seal the lamination space. In the main body 11, an inclined face 11b is formed inside an outer peripheral wall 11a, and under reduced pressure the flexible lid 12 is transformed along the inclined face 11b. Further, the main body 11 is provided with an exhaust outlet 11c, which is connected to a vacuum pump (not shown).

Next, the vacuum lamination will be described specifically.

First, a peeling sheet 13 is disposed on the inner bottom of the main body 11 of the vacuum laminator 10, and a module substrate 1, a first sealing resin sheet 2', a solar cell 3 having a tab wire connected to or temporarily attached on a surface electrode provided on a light receiving face, a second sealing resin sheet 4', and a protective sheet 5 are registered and laminated on the peeling sheet 13. Another peeling sheet 14 is disposed on the laminated body, and the flexible lid 12 covers the sheet. In this case, the above-described sealing resin sheet with a protective layer for a solar batty module can be used instead of the second sealing resin sheet 4' and the protective sheet 5'.

Subsequently, the vacuum laminator 10 is disposed in a heating furnace (not shown), vacuuming is performed from the exhaust outlet 11c in the lamination space, while the sealing resin is heated to a softening or melting temperature. Thus, the laminated body is pressurized by the flexible lid 12 to perform the vacuum lamination, and a solar cell module can be obtained. During the vacuum lamination, the temporarily attached tab wire is connected actually.

### EXAMPLES

Hereinafter, the present invention will be specifically described by way of Examples.

Examples 1 to 2 and Comparative Examples 1 to 3

### (1) Formation of Sealing Resin Sheet

Ester polyol polyurethane (Elastollan ETHD95A, BASF Japan) and ether polyol polyurethane (Elastollan ET370, BASF Japan) in respective blend amounts described in Table 1, and 0.5 parts by mass of epoxy-type silane-coupling agent (KBM-403, Shin-Etsu Chemical Co., Ltd.) were dissolved in tetrahydrofuran to be blended, and a casting method was performed to form a sealing resin sheet having a thickness of 0.4 mm. In Comparative Example 1, an EVA resin sheet having a thickness of 0.5 mm was used as a sealing resin.

### (2) Formation of Solar cell module

A glass module substrate having a thickness of 3 mm was disposed in a vacuum laminator (1016S, Nisshinbo Mechatronics Inc.). On the substrate, the sealing resin sheet formed in the above (1) (a first sealing resin sheet), a solar cell having a thickness of 180 µm, in which a solder-covered copper tab wire as an aluminum surface electrode is attached on a light receiving face with an epoxy-type thermoplastic conductive adhesive temporarily, (Polycrystalline Si cell: IM12525, Motech Industries Inc.), the sealing resin sheet formed in the above (1) (a second sealing resin sheet), and a polyester protective sheet having a thickness of 230 µm (BS-SP, Toppan Printing Co., Ltd.) were sequentially laminated, and the laminated body was subjected to vacuum lamination for 5 minutes in a heating furnace at 150°C so that a pressure of 0.1 MPa was applied to the laminated body. By doing so, a solar cell module was formed.

### Example 3

### (a) Formation of Sealing Resin Sheet with Protective Layer

A blend polymer which is the same blend polymer as used in Example 1 was extruded and molded on a polyester protective sheet, on one surface of which an adhesion layer had been formed (BS-SP, Toppan Printing Co., Ltd.) to form a sealing resin sheet with a protective layer.

### (b) Formation of Solar cell module

A solar cell module was formed in the same manner as in Example 1 except that the sealing resin sheet with a protective layer in the above (a) was laminated instead of laminating the sealing resin sheet in (1) of Example 1 (second sealing resin sheet) and the protective sheet on the solar cell.

### Example 4

A solar cell module was formed in the same manner as in Example 1 except that the EVA resin sheet used in Comparative Example 1 was used instead of the first sealing resin sheet in Example 1.

### <Evaluation>

### (Adhesion Force)

The solar cell modules obtained in Examples 1 to 4 and Comparative Examples 1 to 3 were subjected to vacuum lamination, and after that, held for 1000 hours under an environment of a temperature of 85°C and a humidity of 85%. The adhesion force against a glass module substrate was measured at a peeling rate of 50 mm/min through 180° peeling test in accordance with JIS-K6854-2. The obtained results are shown in Table 1.

### (Corrosion Resistance)

The solar cell modules obtained in Examples 1 to 4 and Comparative Examples 1 to 3 were held for 1000 hours under an environment of a temperature 85°C and a humidity of 85%. After that, the solar cell modules were visually observed with an optical microscope to determine whether or not corrosion (discoloration) occurred on an aluminum surface electrode of the solar cell modules. The obtained results are shown in Table 1.

### (Burning resistance)

The sealing resin sheets obtained in Examples 1 to 4 and Comparative Examples 1 to 3 were cut into 13 mm in width and 125 mm in length, and the cut sheets were observed to determine whether or not they were burnt in a condition of 10-second burning in accordance with UL 94 standard. The obtained results are shown in Table 1.

**[Table 1]**

| | RATIO BY MASS ESTER POLYOL POLYURETHANE : ETHER POLYOL POLYURETHANE | ADHESION FORCE (N/cm) | CORROSION RESISTANCE | BURNING RESISTANCE |
|---|---|---|---|---|
| EXAMPLE 1 | 50:50 | 24 | NOT CORRODED | NOT BURNED |
| EXAMPLE 2 | 30:70 | 21 | NOT CORRODED | NOT BURNED |
| EXAMPLE 3 | 50:50 | 24 | NOT CORRODED | NOT BURNED |
| EXAMPLE 4 | 50:50 FIRST SEALING RESIN LAYER IS EVA RESIN LAYER. | 24 | NOT CORRODED | NOT BURNED |
| COMPARATIVE EXAMPLE 1 | 10:90 | 6 | NOT CORRODED | NOT BURNED |
| COMPARATIVE EXAMPLE 2 | 60:40 | 1 | NOT CORRODED | NOT BURNED |
| COMPARATIVE EXAMPLE 3 | FIRST AND SECOND SEALING RESIN LAYERS ARE EVA RESIN LAYERS | 15 | CORRODED | BURNED |

As seen from Table 1, the solar cell modules in Examples 1 to 3 using the blend polymer including the ester polyol polyurethane and the ether polyol polyurethane in the ration of 30:70 to 50:50 by mass as a sealing resin of the first and second sealing resin layers, even after they were held for 1000 hours under an environment of a temperature 85°C and a humidity of 85%, showed suppression of decrease in adhesion force without corrosion occurring. Further, the solar cell modules had favorable burning resistance. Further, the solar cell module in Example 4 which was formed in the same manner as in Example 1, except the use of an EVA resin layer as the first sealing resin layer on the light receiving face side also showed favorable results. Accordingly, it is found that the blend polymer including the ester polyol polyurethane and the ether polyol polyurethane in a ratio of 30:70 to 50:50 by mass has to be used at least for the second sealing resin layer on a protective sheet side.

On the other hands, in the solar cell modules in Comparative Examples 1 to 2, in which the ratio of the ester polyol polyurethane to the ether polyol polyurethane in the blend polymer used as a sealing resin is out of a range of 30:70 to 50:50 by mass, a decrease in adhesion force was remarkable. The solar cell module in Comparative Example 3 using EVA as a sealing resin had problems in corrosion resistance and burning resistance.

### INDUSTRIAL APPLICABILITY

The solar cell module of the present invention utilizes a thermoplastic blend polymer of an ester polyol polyurethane and an ether polyol polyurethane in a predetermined blend ratio, which shows favorable adhesion force, difficulty in hydrolysis (i.e., properties for substantially suppressing corrosion of electrodes), and favorable burning resistance, as a sealing resin. Accordingly, the solar cell module of the present invention can maintain initial performances over a long period of time, and is useful as a solar cell module showing favorable burning resistance.

### DESCRIPTION OF REFERENCE NUMERALS

- 1: module substrate
- 2: first sealing resin layer
- 3: solar cell
- 4: second sealing resin layer
- 5: protective sheet
- 6: tab wire
- 10: vacuum laminator
- 11: main body
- 11a: outer peripheral wall
- 11b: inclined face
- 11c: exhaust outlet
- 12: flexible lid
- 13: peeling sheet
- 14: peeling sheet

## Claims

1. A solar cell module comprising a module substrate, a first sealing resin layer, a solar cell connected to a tab wire, a second sealing resin layer, and a protective sheet, which are laminated, wherein
the second sealing resin layer is formed from a blend polymer including a thermoplastic polyurethane resin having an ester-type polyol unit and a thermoplastic polyurethane resin having an ether-type polyol unit, and a blend ratio of the thermoplastic polyurethane resin having the ester-type polyol unit to the thermoplastic polyurethane resin having the ether-type polyol unit in the blend polymer is 20:80 to 50:50 by mass.

2. The solar cell module according to claim 1, wherein the first sealing resin layer is formed from a blend polymer including a thermoplastic polyurethane resin having an ester-type polyol unit and a thermoplastic polyurethane resin having an ether-type polyol unit, and a blend ratio of the thermoplastic polyurethane resin having the ester-type polyol unit to the thermoplastic polyurethane resin having the ether-type polyol unit in the blend polymer is 30:70 to 50:50 by mass.

3. The solar cell module according to claim 1 or 2, wherein the second sealing resin layer and the protective sheet are integrated in advance so as to be a sealing resin sheet with a protective layer.

4. The solar cell module according to claim 1 or 2, wherein the solar cell is provided with a surface electrode on a light receiving surface, and the tab wire is connected to the surface electrode with a conductive adhesive.

5. A production method of a solar cell module comprising: putting a laminated body obtained by laminating a module substrate, a first sealing resin sheet, a solar cell connected to or temporarily attached on a tab wire, a second sealing resin sheet, and a protective sheet, in a vacuum laminator; and performing vacuum lamination to simultaneously integrate the laminated body, thereby obtaining the solar cell module according to claim 1, wherein
as the second sealing resin sheet, used is a sealing resin sheet which is formed from a blend polymer including a thermoplastic polyurethane resin having an ester-type polyol unit and a thermoplastic polyurethane resin having an ether-type polyol unit, and has a blend ratio of the thermoplastic polyurethane resin having the ester-type polyol unit to the thermoplastic polyurethane resin having the ether-type polyol unit in the blend polymer of 20:80 to 50:50 by mass.

6. The production method according to claim 5, wherein as the first sealing resin sheet, used is a sealing resin sheet which is formed from a blend polymer including a thermoplastic polyurethane resin having an ester-type polyol unit and a thermoplastic polyurethane resin having an ether-type polyol unit, and has a blend ratio of the thermoplastic polyurethane resin having the ester-type polyol unit to the thermoplastic polyurethane resin having the ether-type polyol unit in the blend polymer of 30:70 to 50:50 by mass.

7. The production method according to claim 5 or 6, wherein as the second sealing resin sheet and the protective sheet, used is a sealing resin sheet with a protective layer in which they are integrated in advance.

8. A sealing resin sheet for a solar cell module, wherein the sealing resin sheet is formed from a blend polymer including a thermoplastic polyurethane resin having an ester-type polyol unit and a thermoplastic polyurethane resin having an ether-type polyol unit, and a blend ratio of the thermoplastic polyurethane resin having the ester-type polyol unit to the thermoplastic polyurethane resin having the ether-type polyol unit in the blend polymer is 20:80 to 50:50 by mass.

9. A sealing resin sheet with a protective layer for a solar cell module, wherein the sealing resin sheet for a solar cell module according to claim 8 is laminated on a protective sheet.
